# EUROPÄISCHE PATENTSCHRIFT

(11) **EP 3 684 081 B1**
(45) Veröffentlichungstag und Bekanntmachung des Hinweises auf die Patenterteilung: **27.04.2022**
(21) Anmeldenummer: 20152246.3
(22) Anmeldetag: 16.01.2020
(51) Int. Cl.: H04R 31/00, H04R 17/00

(54) **HERSTELLUNGSVERFAHREN FÜR MEHRERE MEMS-SCHALLWANDLER**
MANUFACTURING METHOD FOR MULTIPLE MEMS SOUND TRANSDUCERS
PROCÉDÉ DE FABRICATION D'UNE PLURALITÉ DE TRANSDUCTEURS ACOUSTIQUES MEMS

(30) Priorität: 17.01.2019 DE 102019101227; 18.01.2019 DE 102019101325
(43) Veröffentlichungstag der Anmeldung: 22.07.2020
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT); RENAUD-BEZOT, Nick, 1050 Wien (AT)
(74) Vertreter: Canzler & Bergmeier Patentanwälte Partnerschaft mbB

(56) Entgegenhaltungen:
- WO-A1-2016/180841
- DE-A1-102015 107 560
- DE-A1-102015 116 640

## Beschreibung

Die vorliegende Erfindung betrifft ein Herstellungsverfahren für mehrere MEMS-Schallwandler, insbesondere zum Erzeugen und/oder Erfassen von Schallwellen im hörbaren Wellenlängenspektrum und/oder Ultraschallbereich, sowie einen mit diesem Verfahren hergestellten MEMS-Schallwandler.

Aus der DE 10 2015 107 560 A1 und DE 10 2015 116 640 A1 ist jeweils ein Schallwandler bekannt, der eine mehrschichtige piezoelektrische Struktur umfasst, die über ein Koppelelement mit einer Membran verbunden ist.

Aus der WO 2016/180841 A1 ist ein Verfahren zum Herstellen einer Schallwandleranordnung bekannt, bei dem ein Membranmodul mit einem Leiterplattenmodul verbunden wird, wobei eine Membran des Membranmoduls und eine Aktuatorstruktur des Leiterplattenmoduls, die beide entlang einer gemeinsamen z-Achse auslenkbar sind, zwischen einem Pressstempel und einem Referenzwerkzeug positioniert werden und zwischen diesen beiden verpresst werden, so dass sich die beiden Module in einem ersten Verbindungsbereich miteinander verbinden. Beim Herstellen des Leiterplattenmoduls wird die Aktuatorstruktur an einer Leiterplatte im Bereich einer ersten Öffnung einer Aussparung befestigt. Vor dem Verpressen der beiden Module wird das Referenzwerkzeug über eine der ersten Öffnung gegenüberliegende zweite Öffnung in die Aussparung eingeführt und innerhalb dieser derart positioniert, dass die Aktuatorstruktur und die Membran beim Verpressen durch das Referenzwerkzeug in Position gehalten werden.

Aus der DE 10 2014 216 223 A1 ist ferner ein Verfahren zur Herstellung einer Schallwandlerkomponente bekannt. Bei diesem Herstellungsverfahren wird eine Membran eines Vorläufer-MEMS-Chips zunächst von einer Unterseite und anschließend von einer Oberseite freigeätzt, so dass sich diese entlang einer Hubachse bewegen kann.

Aufgabe der vorliegenden Erfindung ist es, ein Herstellungsverfahren für MEMS-Schallwandler zu schaffen, mit dem MEMS-Schallwandler kostengünstig hergestellt werden können und/oder der Produktionsausschuss reduziert werden kann.

Die Aufgabe wird gelöst durch ein Herstellungsverfahren für mehrere MEMS-Schallwandler mit den Merkmalen des unabhängigen Patentanspruchs.

Vorgeschlagen wird ein Herstellungsverfahren für mehrere MEMS-Schallwandler. Die MEMS-Schallwandler sind insbesondere zum Erzeugen und/oder Erfassen von Schallwellen im hörbaren Wellenlängenspektrum und/oder Ultraschallbereich ausgebildet. Infolgedessen handelt es sich bei den MEMS-Schallwandlern insbesondere um MEMS-Mikrofone und/oder MEMS-Lautsprecher. Bei dem Herstellungsverfahren wird zunächst ein rekonstruierter Wafer hergestellt. Unter dem Begriff "Wafer" werden plattenförmige Elemente bezeichnet, die aus ein- oder polykristallinen Rohlingen hergestellt sind. Sie dienen als Substrat für elektronische Bauelemente, wie beispielsweise Chips. Ein Wafer kann eine kreisrunde oder quadratische Form aufweisen. Im Falle einer quadratischen Form wird ein Wafer auch als Panel bezeichnet. Zur Herstellung des rekonstruierten Wafers werden mehrere Chips eines Wafers voneinander getrennt und beabstandet voneinander, insbesondere auf einem Träger, angeordnet. Anschließend werden diese voneinander beabstandet angeordneten Chips mit einer Formmasse umgossen. Bei der Formmasse handelt es sich insbesondere um einen Kunststoff. Des Weiteren wird bei den Chips des rekonstruierten Wafers jeweils zumindest ein Piezoelement freigestellt, so dass dieses, insbesondere ein freies Ende des Piezoelements, entlang einer Hubachse auslenkbar ist. Das Piezoelement ist vorzugsweise ein Kragarm mit zumindest einer piezoelektrischen Schicht, dessen eines Ende ortsfest befestigt ist und dessen anderes Ende ausgelenkt werden kann.

Das Freistellen des zumindest einen Piezoelements erfolgt erst nachdem die voneinander beabstandeten Chips mit der Formmasse umgossen wurden. Hierdurch wird das Risiko einer Beschädigung des zumindest einen Piezoelements, insbesondere wenn der rekonstruierte Wafer als Halbzeug verschickt oder transportiert wird und während der anschließenden Verfahrensschritte bearbeitet wird, reduziert. Vorteilhaft ist es, wenn das Freistellen des zumindest einen Piezoelements erst nach dem Aushärten der Formmasse erfolgt. Das zumindest eine Piezoelement ist vor dem Freistellen zumindest an einer seiner beiden Seiten durch ein Material bedeckt, das eine Auslenkung des Piezoelements verhindert. Unter dem Begriff "Freistellen" ist das derartige Freilegen des Piezoelements an seiner Oberseite und/oder Unterseite und/oder derartige Formen der Seitenkontur des Piezoelementes zu verstehen, so dass dieses, insbesondere dessen freies und/oder bewegbares Ende, entlang der Hubachse ausgelenkt werden kann.

Bei dem Piezoelement handelt es sich insbesondere um einen piezoelektrischen Aktor, mit dem zum Erzeugen von Schallwellen eine Membran ausgelenkt werden kann. Zusätzlich oder alternativ handelt es sich bei dem Piezoelement insbesondere um einen piezoelektrischen Sensor, mit dem zum Erfassen von Schallwellen eine Auslenkung der Membran detektiert werden kann.

Auch wird der rekonstruierte Wafer bei dem vorgeschlagenen Herstellungsverfahren mit mehreren den jeweiligen Chips zugeordneten Membranen verbunden. Hierbei werden die Membrane jeweils mit dem zumindest einen zugeordneten Piezoelement, insbesondere unmittelbar oder mittelbar über zumindest ein weiteres dazwischen angeordnetes Element, derart verbunden, dass die Membrane, nachdem die Piezoelemente freigestellt wurden, jeweils gemeinsam mit dem zumindest einen zugeordneten Piezoelement entlang der Hubachse auslenkbar sind. Im freigestellten Zustand kann das jeweils zumindest eine Piezoelement somit gemeinsam mit der zugeordneten Membran entlang der Hubachse bewegt werden.

Vorteilhaft ist es, wenn mehrere, insbesondere alle, der für die jeweiligen Chips vorgesehenen Membrane zusammenhängend und/oder in Form eines gemeinsamen Membranelements ausgebildet sind, das an der dafür vorgesehenen Seite des rekonstruierten Wafers mit diesem verbunden wird. Hierdurch können mehrere Membrane in einem einzigen Verfahrensschritt angebracht werden, wodurch die Herstellungskosten reduziert werden können. Das Membranelement wird dann später in die einzelnen Membrane zerteilt.

Alternativ können die Membrane, bereits bevor sie am rekonstruierten Wafer angebracht werden, voneinander getrennt sein und/oder einzeln mit den jeweils zugeordneten Chips verbunden werden. Demnach ist es insbesondere vorteilhaft, wenn der rekonstruierte Wafer mit mehreren den jeweiligen Chips zugeordneten Membraneinheiten verbunden wird. Eine Membraneinheit kann einen Membranträger und zumindest eine von diesem in ihrem Randbereich gehaltene Membran umfassen. Beim Verbinden wird eine Membran der jeweiligen Membraneinheit mit dem zumindest einen zugeordneten Piezoelement verbunden. Dies kann unmittelbar oder mittelbar über ein dazwischen angeordnetes Koppelelement erfolgen. Im freigestellten Zustand kann das Piezoelement somit gemeinsam mit der Membran entlang der Hubachse bewegt werden.

Insbesondere am Ende des Herstellungsverfahrens werden die MEMS-Schallwandler, die dann jeweils einen Chip und eine Membran, insbesondere als Teil einer Membraneinheit, umfassen, vereinzelt.

Mit dem vorstehenden Herstellungsverfahren können mehrere MEMS-Schallwandler sehr kostengünstig hergestellt werden. Dies ist beispielsweise darauf zurückzuführen, dass durch die Formmasse des rekonstruierten Wafers Material des jeweiligen Chips (insbesondere seines Substrats), das im Vergleich zur Formmasse teurer ist, eingespart werden kann. Des Weiteren wird das Herstellungsverfahren durch den separaten Schritt des Verbindens des rekonstruierten Wafers mit mehreren den jeweiligen Chips zugeordneten Membranen, insbesondere Membraneinheiten, vereinfacht. Zusätzlich oder alternativ wird hierdurch der Ausschuss beim Herstellen der MEMS-Schallwandler reduziert, da das jeweilige zumindest eine Piezoelement erst nach dem Umgießen mit der Formmasse freigestellt wird.

Vorteilhaft ist es, wenn das zumindest eine Piezoelement der jeweiligen Chips erst nach dem Umgießen mit der Formmasse, aber vor dem Verbinden, insbesondere Verkleben, mit der zugeordneten Membran freigestellt wird. Hierdurch kann eine Beschädigung des zumindest einen Piezoelements beim Transport des rekonstruierten Wafers vermieden werden. Alternativ ist es vorteilhaft, wenn das zumindest eine Piezoelement der jeweiligen Chips zwar nach dem Umgießen mit der Formmasse, aber vor dem Verbinden mit der zugeordneten Membran freigestellt wird. Hierdurch kann zumindest eine Beschädigung der Piezoelemente beim Umgießen mit der Formmasse ausgeschlossen werden.

Bei einer vorteilhaften Weiterbildung der Erfindung ist es vorteilhaft, wenn das zumindest eine Piezoelement der jeweiligen Chips erst nach dem Verbinden, insbesondere Verkleben, mit der zugeordneten Membran freigestellt wird. Infolgedessen ist das zumindest eine Piezoelement vor und während des Verbindens noch nicht in Richtung der Hubachse auslenkbar, sondern unbeweglich vom Material des Chips und/oder der Formmasse gehalten. Hierdurch kann eine Beschädigung des zumindest einen Piezoelements beim Verbinden mit der Membran verhindert werden. So muss auf das Piezoelement beim Verbinden der Membran in Richtung der Hubachse eine Kraft auf die beiden miteinander zu verbindenden Komponenten ausgeübt werden. Wenn das Piezoelement bereits freigestellt ist, würde dieses durch die einseitig einwirkende Verbindungskraft derart stark ausgelenkt werden, dass dieses beschädigt werden würde. Um dies zu verhindern, ist es vorteilhaft, wenn das zumindest eine Piezoelement nicht vor, sondern erst nach dem Verbinden mit der Membran freigestellt wird.

Vorteilhaft ist es, wenn, insbesondere mit einem Ätzverfahren oder Laserbearbeitungsverfahren, von einer ersten Seite des rekonstruierten Wafers ein Teil des rekonstruierten Wafers bereichsweise bis zu einer ersten Seite des jeweils zugeordneten Piezoelements entfernt wird. Hierbei handelt es sich vorzugsweise um einen ersten Freistellungsteilschritt.

Auch ist es vorteilhaft, wenn der rekonstruierte Wafer von seiner ersten Seite derart entfernt wird, dass für die MEMS-Schallwandler jeweils ein Tragrahmen und/oder ein im Inneren des Tragrahmens angeordnetes Koppelelement ausgebildet werden.

Vorteilhaft ist es, wenn in einem ersten Freistellungsteilschritt, insbesondere mittels eines Ätzverfahrens oder eines Laserbearbeitungsverfahrens, ein Teil des rekonstruierten Wafers bis zu einer ersten Seite des jeweils zugeordneten Piezoelements entfernt wird, so dass das Piezoelement an dieser Seite freiliegt. Vorteilhaft ist es, wenn in einem nachgelagerten zweiten Freistellungsteilschritt, insbesondere mittels eines Ätzverfahrens oder eines Laserbearbeitungsverfahrens, ein Teil des rekonstruierten Wafers bis zu einer zweiten Seite des jeweils zugeordneten Piezoelements entfernt wird, so dass das Piezoelement auch an dieser Seite freiliegt. Vorteilhaft ist es, wenn die Außenkontur, insbesondere die Kragarmform, des zumindest einen Piezoelements, insbesondere mittels eines Ätzverfahrens oder eines Laserbearbeitungsverfahrens, insbesondere mit dem ersten oder zweiten Freistellungsteilschritt, aus einer das Piezoelement bildenden Piezoschicht freigeschnitten wird. Alternativ kann dies auch in einem dem ersten oder zweiten Freistellungsteilschritt nachgelagerten separaten Materialentfernungsschritt erfolgen. Das Verfahren kann sehr einfach und schnell ausgebildet werden, wenn auf der ersten Seite des rekonstruierten Wafers eine erste Maskierungsschicht angeordnet wird, die mehrere den Chips zugeordnete erste Öffnungen aufweist. Nach dem Aufbringen der ersten Maskierungsschicht ist somit jedem Chip des rekonstruierten Wafers zumindest eine erste Öffnung zugeordnet. Anschließend wird auf diese erste Maskierungsschicht ein Ätzmittel, insbesondere eine Flüssigkeit oder ein Gas, aufgebracht. Bei dem Ätzverfahren handelt es sich vorzugsweise um ein Trocken-Ätzverfahren oder Nass-Ätzverfahren. Das Ätzmittel kann im Bereich der ersten Öffnungen mit dem rekonstruierten Wafer in Kontakt treten. Hierdurch wird im Bereich der ersten Öffnungen ein Teil des rekonstruierten Wafers bis zu der ersten Seite des jeweils zugeordneten Piezoelements weggeätzt. Je nach Ausgestaltung des rekonstruierten Wafers kann hierdurch bereits eine Freistellung der jeweiligen Piezoelemente erfolgen, nämlich, wenn dieser auf der zweiten Seite des Piezoelements kein Material aufweist. In diesem Fall wird vorzugsweise die erste Maskierungsschicht mit dem Ätzmittel erst nach dem Befestigen der Membraneinheiten mit dem rekonstruierten Wafer auf diesen aufgebracht. Alternativ kann der rekonstruierte Wafer aber auch derart ausgebildet sein, dass bei diesem Verfahrensschritt das jeweilige Piezoelement noch nicht freigestellt wird, nämlich dann, wenn auf der zweiten Seite des Piezoelements noch Material angeordnet ist. In diesem Fall ist es vorteilhaft, wenn die erste Maskierungsschicht mit dem Ätzmittel bereits vor dem Verbinden der Membraneinheiten mit den jeweiligen Chips auf den rekonstruierten Wafer aufgebracht wird. Hierdurch kann die erste Seite des Piezoelements mit dem Ätzmittel freigelegt werden, wohingegen das Piezoelement auf seiner gegenüberliegenden zweiten Seite noch durch ein Material des rekonstruierten Wafers fest in Position gehalten wird.

Vorteilhaft ist es, wenn die ersten Öffnungen jeweils derart ausgebildet werden, dass der rekonstruierte Wafer, insbesondere ein Substrat des jeweiligen Chips, in einem für den Tragrahmen des jeweiligen MEMS-Schallwandlers vorgesehenen Außenbereich durch die erste Maskierungsschicht maskiert, d.h. überdeckt, ist. Hierdurch kann vorteilhafterweise ein erster Hohlraum ausgebildet werden, der im Inneren des Tragrahmens des jeweiligen MEMS-Schallwandlers ausgebildet ist.

Diesbezüglich ist es zusätzlich oder alternativ vorteilhaft, wenn die ersten Öffnungen jeweils derart ausgebildet werden, dass der rekonstruierte Wafer, insbesondere das Substrat des jeweiligen Chips, in einem für das Koppelelement des jeweiligen MEMS-Schallwandlers vorgesehenen Innenbereich durch die erste Maskierungsschicht maskiert ist. Der Innenbereich ist hierbei vorzugsweise von dem Außenbereich umgeben und von diesem, insbesondere vollumfänglich, beabstandet. Der Innenbereich bildet somit eine Insel im Inneren des Außenbereichs. Hierdurch kann im Inneren des Tragrahmens das gegenüber diesem in Richtung der Hubachse frei bewegliche Koppelelement ausgebildet werden. Bei dem Koppelelement handelt es sich somit um ein vom Piezoelement in Richtung der Hubachse abstehendes Bauteil, das vorzugsweise aus dem Substrat des jeweiligen Chips ausgebildet ist und/oder im Bereich seines freien Endes mit der dafür vorgesehenen Membran verbunden werden kann. Das Koppelelement verbindet somit beim fertigen MEMS-Schallwandler das zumindest eine Piezoelement mittelbar mit der Membran. Das Koppelelement wird hierdurch im Inneren des ersten Hohlraums ausgebildet.

Vorteilhaft ist es, wenn der rekonstruierte Wafer, insbesondere von seiner ersten Seite und/oder im Bereich der Öffnungen, jeweils derart entfernt, insbesondere weggeätzt, wird, dass das zumindest eine Piezoelement an seinem ersten Ende mit dem Tragrahmen und/oder an seinem zweiten Ende mit dem Koppelelement verbunden ist und/oder an seinen beiden gegenüberliegenden Längsseiten freigestellt ist. Vorzugsweise ist das zumindest eine Piezoelement zu diesem Zeitpunkt noch nicht freigestellt. An seiner dem Koppelelement gegenüberliegenden zweiten Seite befindet sich somit noch Material, dass das Piezoelement in Position hält.

Insbesondere nach dem Freilegen der ersten Seite des Piezoelements wird in einer vorteilhaften Weiterentwicklung der Erfindung das zumindest eine Piezoelement der jeweiligen Chips, insbesondere im Bereich seines zweiten Endes und/oder mittelbar über das Koppelelement, mit der Membran verbunden, insbesondere verklebt. Hierbei wird die Membran mit dem zumindest einen Piezoelement in Richtung der Hubachse verpresst. Da das zumindest eine Piezoelement zu diesem Zeitpunkt noch nicht freigestellt ist, kann die beim Verpressen auf das Piezoelement einwirkende Kraft über das auf der anderen Seite des Piezoelements noch vorhandene Material abgeleitet werden. Hierdurch wird eine Beschädigung des Piezoelements verhindert. Vorzugsweise wird das Piezoelement mittelbar über das Koppelelement mit der Membran verbunden. Hierbei wird die Membran vorzugsweise an einem vom Piezoelement abgewandten Ende des Koppelelements mit diesem verpresst.

Vorteilhaft ist es, wenn die Membran an einem dem Piezoelement in Richtung der Hubachse abgewandten Ende des Koppelelements mit diesem verbunden wird. Vorteilhafterweise kann somit eine Seite des ausgesparten Chips mit einem Kleber versehen werden, der dann das freie Ende des Koppelelements und eine Seite des Tragrahmens benetzt.

Auch ist es vorteilhaft, wenn die Membran unmittelbar mit dem Tragrahmen verbunden wird. Alternativ ist es vorteilhaft, wenn die Membran mittelbar über einen die Membran in ihrem Randbereich haltenden Membranrahmen mit dem Tragrahmen verbunden wird. Vorteilhafterweise bildet ein Membranrahmen zusammen mit seiner Membran eine Membraneinheit aus. Das Verbinden der Membran mit dem Tragrahmen erfolgt vorzugsweise gleichzeitig beim Verbinden der Membran mit dem Koppelelement. Vorzugsweise wird der Membranrahmen mit dem Substrat des Chips und/oder mit der diesem Chip zugeordneten Formmasse verbunden.

Vorteilhaft ist es, wenn die Membrane auf den rekonstruierten Wafer einzeln, insbesondere als Membraneinheiten, oder gemeinsam als zusammenhängendes Membranelement aufgebracht werden.

Auch ist es vorteilhaft, wenn, insbesondere mit einem Ätzverfahren oder Laserbearbeitungsverfahren, von einer der ersten Seite gegenüberliegenden zweiten Seite des rekonstruierten Wafers ein Teil des rekonstruierten Wafers bereichsweise bis zu einer zweiten Seite des jeweils zugeordneten Piezoelements entfernt wird.

In einer vorteilhaften Weiterbildung der Erfindung wird zum Freistellen des zumindest einen Piezoelements auf der der ersten Seite gegenüberliegenden zweiten Seite des rekonstruierten Wafers eine zweite Maskierungsschicht angeordnet. Die zweite Maskierungsschicht weist vorzugsweise mehrere den Chips zugeordnete zweite Öffnungen auf. Infolgedessen ist jedem der Chips vorzugsweise zumindest eine zweite Öffnung zugeordnet.

Auch ist es vorteilhaft, wenn zum Freistellen des zumindest einen Piezoelements auf dieser zweiten Maskierungsschicht ein Ätzmittel aufgebracht wird. Hierdurch wird im Bereich der zweiten Öffnungen ein Teil des rekonstruierten Wafers bis zu der zweiten Seite des jeweils zugeordneten Piezoelements weggeätzt. Das zumindest eine Piezoelement der Chips weist somit weder an seiner ersten Seite noch an seiner zweiten Seite Material auf, das das Piezoelement mit dem Tragrahmen starr verbindet bzw. in Position hält. Stattdessen ist das Piezoelement nunmehr freigestellt, so dass dieses entlang der Hubachse ausgelenkt werden kann.

Vorteilhaft ist es, wenn die zweiten Öffnungen jeweils derart ausgebildet werden, dass der rekonstruierte Wafer, insbesondere die dem jeweiligen Chip zugeordnete Formmasse, in einem für eine Kavitätswandung des jeweiligen MEMS-Schallwandlers vorgesehenen Außenbereich durch die zweite Maskierungsschicht maskiert, d.h. bedeckt, ist. Der Außenbereich stellt somit einen rahmenförmig geschlossenen Bereich dar, in dessen Inneren ein zweiter Hohlraum ausgebildet wird. Der erste Hohlraum ist somit vorzugsweise an der ersten Seite des Piezoelements und/oder der zweite Hohlraum an der zweiten Seite des Piezoelements ausgebildet. Das Piezoelement kann somit im freigestellten Zustand sowohl in den ersten als auch in den zweiten Hohlraum hineinschwingen.

Vorteilhaft ist es, wenn von der ersten Seite des rekonstruierten Wafers das Substrat der jeweiligen Chips und/oder von der zweiten Seite des rekonstruierten Wafers die den jeweiligen Chips zugeordnete Formmasse weggeätzt wird.

Auch ist es vorteilhaft, wenn die erste und/oder zweite Maskierungsschicht nach dem Ätzvorgang wieder entfernt wird.

Vorteilhaft ist es, wenn zur Ausbildung der Kontur des Piezoelements das Piezoelement selbst in einem Randbereich, insbesondere mittels eines Lasers, entfernt wird. Der Chip weist vorzugsweise eine piezoelektrische Struktur auf. Hierbei handelt es sich um zumindest eine piezoelektrische Schicht, die auf dem Substrat aufgebracht ist. Beim Ausbilden der Kontur des Piezoelements wird diese Schicht entlang der Kontur durchtrennt.

Vorteilhaft ist es, wenn das Piezoelement selbst in seinem Randbereich entweder nach dem Freilegen seiner ersten Seite oder nach dem Freilegen seiner zweiten Seite konturiert und/oder beschnitten wird.

Zur Herstellung des rekonstruierten Wafers ist es vorteilhaft, wenn die voneinander getrennten Chips vor dem Umgießen mit der Formmasse auf einem Träger angeordnet, insbesondere aufgeklebt, werden. Der Träger dient somit als zwischenzeitliche Fixierung der Chips, um diese mit der Formmasse Umgießen zu können.

Diesbezüglich ist es ferner vorteilhaft, wenn der Träger nach dem Aushärten der Formmasse wieder entfernt wird. Vorzugsweise wird der Träger derart angeordnet und/oder derart entfernt, dass die Chips nach dem Umgießen in der Formmasse eingekapselt sind und nach dem Entfernen des Trägers an der ersten Seite des rekonstruierten Wafers freiliegen.

Um die MEMS-Schallwandler möglichst dünn auszubilden, ist es vorteilhaft, wenn der rekonstruierte Wafer an seiner ersten Seite zur Reduktion seiner Dicke teilweise abgetragen, insbesondere abgeschliffen, wird. In diesem Fall ist es vorteilhaft, wenn zuvor auf der zweiten Seite des rekonstruierten Wafers ein Hilfsträger angeordnet wird, der vorzugsweise nach dem Abschleifen wieder entfernt wird.

Auch ist es vorteilhaft, wenn auf der ersten und/oder zweiten Seite des rekonstruierten Wafers eine elektrische Isolationsschicht und/oder eine metallische Umverteilungsschicht zum Umverteilen von Kontaktstellen des jeweiligen Chips aufgebracht werden. Die Umverteilungsschicht wird vorzugsweise vor dem Aufbringen der Maskierungsschicht angeordnet, so dass diese während des Ätzvorgangs von der Maskierungsschicht geschützt ist.

Vorteilhaft ist es, wenn die Isolationsschicht beim Umgießen der Chips durch die Formmasse ausgebildet wird.

Vorteilhaft ist es, wenn der rekonstruierte Wafer in einem Chip-First-Verfahren hergestellt wird. Hierbei werden die Chips zuerst mit der Formmasse umgossen und erst danach wird die Umverteilungsschicht ausgebildet.

Alternativ ist es vorteilhaft, wenn der rekonstruierte Wafer in einem Chip-Last-Verfahren hergestellt wird. Hierbei wird zuerst die Umverteilungsschicht ausgebildet und erst danach werden die Chips auf dieser Umverteilungsschicht angeordnet und mit der Formmasse umgossen.

Vorteilhaft ist es, wenn der rekonstruierte Wafer in einem Face-Down-Verfahren hergestellt wird, bei dem die vereinzelten Chips vor dem Umgießen und/oder zum Umgießen mit der Formmasse derart angeordnet werden, dass ihre Kontaktstellen nach unten zeigen.

Vorteilhaft ist es, wenn der rekonstruierte Wafer in einem Face-Up-Verfahren hergestellt wird, bei dem die vereinzelten Chips vor dem Umgießen und/oder zum Umgießen mit der Formmasse derart angeordnet werden, dass ihre Kontaktstellen nach oben zeigen.

Weitere Vorteile der Erfindung sind in den nachfolgenden Ausführungsbeispielen beschrieben. Es zeigt:
- **Figur 1**: eine schematische Schnittansicht eines MEMS-Schallwandlers und
- **Figur 2 - 12**: die einzelnen Verfahrensschritte zur Herstellung mehrerer MEMS-Schallwandler gemäß Figur 1.

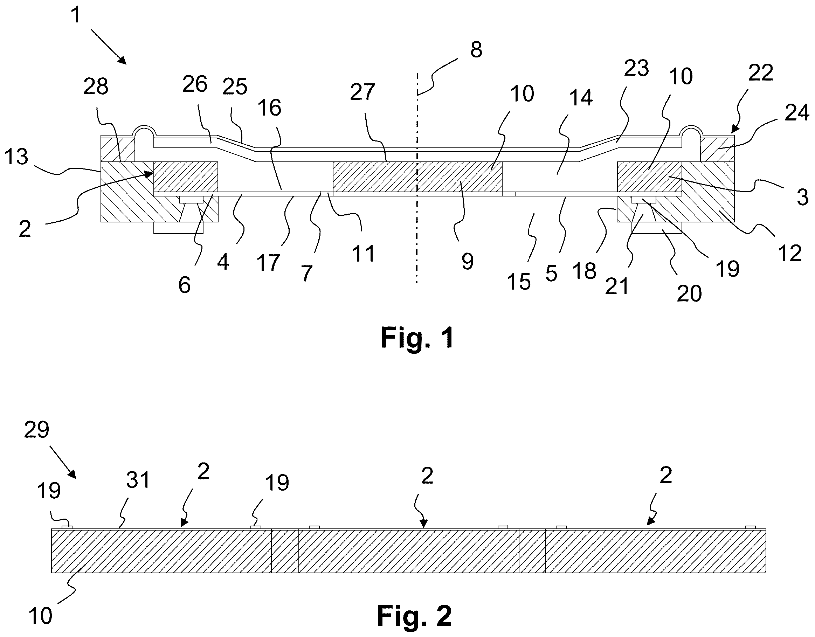

Figur 1 zeigt einen MEMS-Schallwandler 1, insbesondere zum Erzeugen und/oder Erfassen von Schallwellen im hörbaren Wellenlängenspektrum und/oder Ultraschallbereich. Dieser MEMS-Schallwandler 1 wird beispielsweise in einem Herstellungsverfahren gemäß den in den Figuren 2 bis 12 dargestellten Verfahrensschritten hergestellt.

Gemäß Figur 1 umfasst der MEMS-Schallwandler 1 einen Chip 2, der zumindest einen Tragrahmen 3 und zumindest ein Piezoelement 4, 5 ausbildet.

Der MEMS-Schallwandler 1 umfasst ein erstes Piezoelement 4 und ein zweites Piezoelement 5 Alternativ kann der MEMS-Schallwandler 1 aber auch nur ein einziges Piezoelement 4, 5 oder aber auch mehr als zwei Piezoelemente 4, 5 umfassen. Das erste Piezoelement 4 ist an seinem ersten Ende 6 mit dem Tragrahmen 3 verbunden. Ein zweites Ende 7 des ersten Piezoelements 4 kann entlang einer Hubachse 8 ausgelenkt werden. Hierfür ist das Piezoelement 4 an seinen Seiten freigeschnitten. Des Weiteren umfasst der MEMS-Schallwandler 1 ein Koppelelement 9. Dieses ist im Inneren des Tragrahmens 3 angeordnet. Das Koppelelement 9 und der Tragrahmen 3 sind aus einem Substrat 10 des Chips 2 ausgebildet. Das erste Piezoelement 4 ist mit seinem zweiten Ende 7 mit dem Koppelelement 9 verbunden. Dies ist vorliegend über flexible und/oder gelenkige Verbindungselemente 11 realisiert. Das zweite Piezoelement 5 ist in analoger Weise mit dem Tragrahmen 3 und dem Koppelelement 9 verbunden. Über das erste und zweite Piezoelement 4, 5 kann das Koppelelement 9 entlang der Hubachse 8 ausgelenkt werden. Ebenso kann von dem ersten und zweiten Piezoelement 4, 5 eine Bewegung des Koppelelements 9 entlang der Hubachse 8 erfasst werden.

Gemäß Figur 1 ist der Chip 2 mit einer Formmasse 12 teilweise umgossen. Bei der Formmasse 12 handelt es sich vorzugsweise um einen spritzfähigen Kunststoff, mit dem der Chip 2 während des Herstellungsverfahrens umspritzt wird. Die Formmasse 12 bildet einen Teil des Tragrahmens 3 und/oder eines Gehäuses 13 des MEMS-Schallwandlers 1.

Der Chip 2 weist einen ersten Hohlraum 14 auf. In diesem ersten Hohlraum 14 ist das Koppelelement 9 angeordnet. Des Weiteren ist ein zweiter Hohlraum 15 des MEMS-Schallwandlers 1 in der Formmasse 12 ausgebildet. Der erste Hohlraum 14 befindet sich somit an einer ersten Seite 16 des jeweiligen Piezoelements 4, 5 und der zweite Hohlraum 15 an einer zweiten Seite 17 des jeweiligen Piezoelements 4, 5. Die Piezoelemente 4, 5 können somit sowohl in den ersten als auch in den zweiten Hohlraum 14, 15 hinein schwingen. Der zweite Hohlraum 15 bildet hierbei eine Kavität bzw. ein Rückraumvolumen des MEMS-Schallwandlers 1. Eine Kavitätswandung 18 des MEMS-Schallwandlers 1 ist somit durch die Formmasse 12 ausgebildet. Der zweite Hohlraum 15 ist auf seiner den Piezoelementen 4, 5 abgewandten Seite offen.

Wie aus Figur 1 hervorgeht weist der Chip 2 für die Piezoelemente 4, 5 des Weiteren Kontaktstellen 19 auf. Außerdem umfasst der MEMS-Schallwandler 1 eine Umverteilungsschicht 20. Diese ist über eine Durchkontaktierung 21 mit zumindest einer der Kontaktstellen 19 verbunden. Die Umverteilungsschicht 20 ist vom Chip 2 durch eine elektrisch isolierende Isolationsschicht getrennt. Diese ist in dem in Figur 1 dargestellten Ausführungsbeispiel durch die Formmasse 12 ausgebildet. Alternativ könnte auch eine zusätzliche Isolationsschicht ausgebildet sein.

Der Chip 2 und die Formmasse 12 bilden eine erste Einheit, die während des Herstellungsverfahrens, das im Folgenden in Bezug auf die Figuren 2 bis 12 noch detailliert erläutert wird, mit einer Membran 23 verbunden wird. Gemäß dem vorliegenden Ausführungsbeispiel ist die Membran 23 Teil einer Membraneinheit 22, die die Membran 23 und einen die Membran 23 in ihrem Randbereich haltenden Membranrahmen 24 umfasst. Ferner umfasst die Membran 23 gemäß dem vorliegenden Ausführungsbeispiel eine flexible Membranschicht 25 sowie eine Versteifungsplatte 26. In einem vorliegend nicht dargestellten Ausführungsbeispiel könnte die Membran 23 aber auch unmittelbar am Substrat 10 und/oder der Formmasse 12 befestigt sein. In diesem Fall wäre beispielsweise der Membranrahmen 24 durch die Formmasse 12 und/oder das Substrat 10 ausgebildet.

Die Membran 23 ist mit dem zumindest einen Piezoelement 4, 5 in einem ersten Verbindungsbereich 27 verbunden, insbesondere verklebt. Gemäß dem vorliegenden Ausführungsbeispiel ist der erste Verbindungsbereich 27 zwischen dem Koppelelement 9 und der Membran 23 ausgebildet. Infolgedessen sind die Piezoelemente 4, 5 mittelbar über das Koppelelement 9 mit der Membran 23 verbunden. Des Weiteren sind die beiden Einheiten in einem zweiten Verbindungsbereich 28 miteinander verbunden. Dieser ist vorliegend zwischen dem Membranrahmen 24 und der Formmasse 12 ausgebildet.

Der vorstehend beschriebene MEMS-Schallwandler 1 kann mit dem nachfolgend im Detail beschriebenen Herstellungsverfahren hergestellt werden, wobei die jeweiligen Verfahrensschritte in den Figuren 2 bis 12 dargestellt sind.

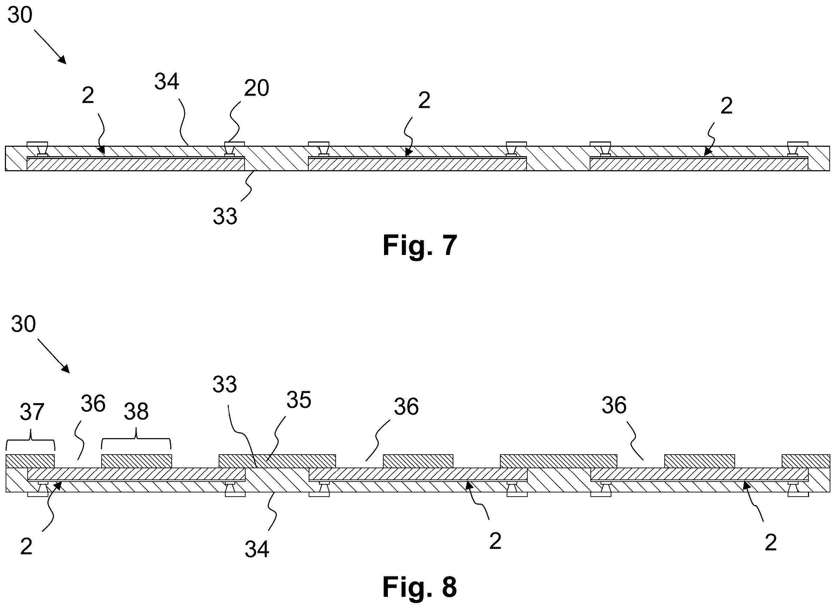

Zu Beginn des Herstellungsverfahrens wird zunächst aus einem in Figur 2 dargestellten Wafer 29 ein in Figur 7 dargestellter rekonstruierte Wafer 30 hergestellt. Unter dem Begriff "Wafer" wird ein plattenförmiges Element bezeichnet, das vorzugsweise aus einem ein- oder polykristallinen Rohling hergestellt ist. Wafer dienen als Substrat für die Chips 2. Der Wafer 29 kann eine kreisrunde oder quadratische Form aufweisen. Im Falle einer quadratischen Form wird der Wafer 29 auch als Panel bezeichnet.

Wie aus Figur 2 hervorgeht umfasst der Wafer 29 mehrere Chips 2, von denen aus Gründen der Übersichtlichkeit nur einer mit Bezugszeichen versehen ist. Die Chips 2 umfassen im Wesentlichen das Substrat 10, auf dem zumindest eine piezoelektrische Schicht 31 angeordnet ist, aus der im Laufe des Herstellungsverfahrens das zumindest eine Piezoelement 4, 5 ausgebildet wird. Die piezoelektrische Schicht 31 kann einen Sandwichverbund mit mehreren Schichten, insbesondere Piezoschichten und/oder Elektrodenschichten, sein.

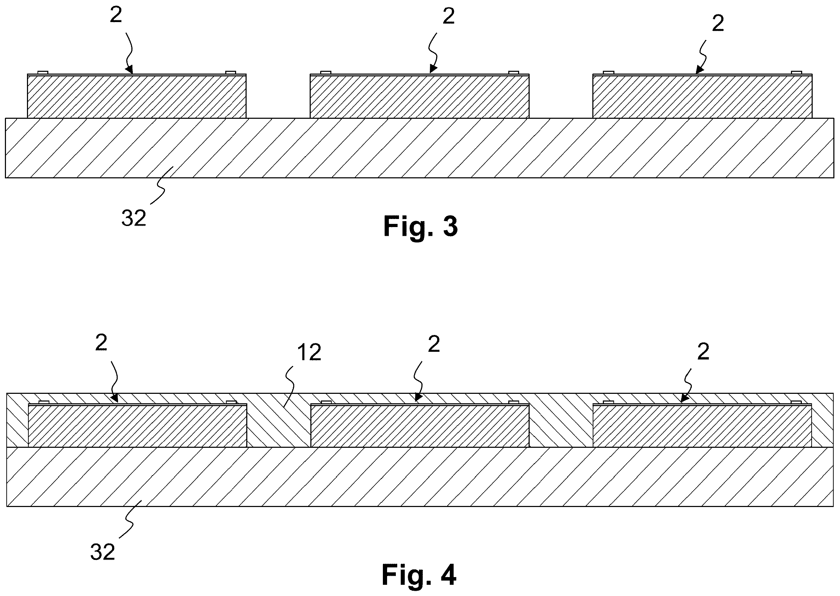

Gemäß Figur 3 werden die Chips 2 voneinander getrennt. Hierfür wird der Wafer 29 zerschnitten. Die voneinander getrennten Chips 2 werden anschließend voneinander beabstandet angeordnet. Dies kann, wie in Figur 3 dargestellt, auf einem Träger 32 erfolgen. Die Chips 2 sind vorzugsweise auf den Träger 32 aufgeklebt.

Wie aus Figur 3 hervorgeht, werden die vereinzelten Chips 2 derart angeordnet, dass ihre Kontaktstellen 19 abbildungsgemäß nach oben zeigen. Die Herstellung erfolgt demnach in einem sogenannten Face-Up-Verfahren. Alternativ könnten die vereinzelten Chips 2 auch in einem vorliegend nicht dargestellten Ausführungsbeispiel derart angeordnet werden, dass ihre Kontaktstellen 19 abbildungsgemäß nach unten zeigen. Die Herstellung würde somit in einem sogenannten Face-Down-Verfahren erfolgen.

Anschließend werden die voneinander beabstandete Chips 2 gemäß Figur 4 mit der Formmasse 12 umgossen, insbesondere umspritzt. Die Chips 2 liegen somit jeweils mit einer ersten Seite am Träger 32 an und sind ansonsten vollständig von der Formmasse 12 eingekapselt.

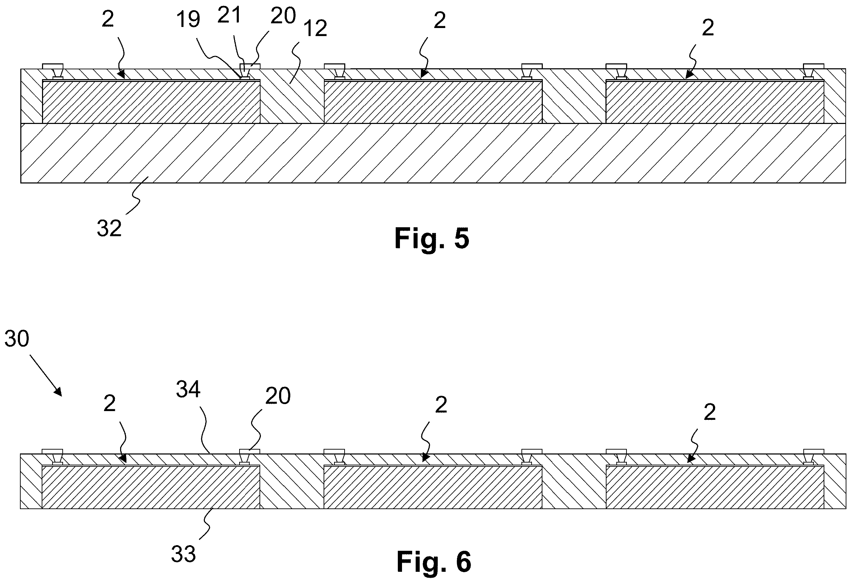

Gemäß Figur 5 wird nach dem Aushärten der Formmasse 12 auf die Formmasse eine Umverteilungsschicht 20 aufgebracht. Die Umverteilungsschicht 20 wird ferner über Durchkontaktierungen 21 mit den Kontaktstellen 19 des jeweiligen Chips 2 verbunden. Vorliegend verlaufen die Durchkontaktierungen 21 durch die Formmasse 12. Zusätzlich oder alternativ könnten diese in einem vorliegend nicht dargestellten Ausführungsbeispiel auch durch das Substrat 10 verlaufen.

Anschließend wird, wie in Figur 6 dargestellt, der Träger 32 entfernt. Nach dem Entfernen des Trägers 32 ist der rekonstruierte Wafer 30 im Wesentlichen fertiggestellt. Die Chips 2 sind somit in der Formmasse 12 eingekapselt und liegen lediglich an einer ersten Seite 33 des rekonstruierten Wafers 30 frei. An der zweiten Seite 34 des rekonstruierten Wafers 30 befindet sich die Umverteilungsschicht 20.

Das vorstehend beschriebene Verfahren zur Herstellung des rekonstruierten Wafers 30 wird als Chip-First-Verfahren bezeichnet, da die vereinzelten Chips 2 zuerst mit der Formmasse 12 umgossen und erst danach mit der Umverteilungsschicht 20 versehen werden.

In einem vorliegend nicht dargestellten alternativen Ausführungsbeispiel könnte der rekonstruierte Wafer 30 auch in einem Chip-Last-Verfahren hergestellt werden. In diesem Fall würde zuerst die Umverteilungsschicht 20 ausgebildet werden. Erst danach würden die Chips 2 auf dieser Umverteilungsschicht 20 aufgebracht und im Anschluss mit der Formmasse 12 umgossen werden.

Um die Dicke des rekonstruierten Wafers 30 zu reduzieren, kann, wie in Figur 7 dargestellt, ein Teil des rekonstruierten Wafers 30 von der ersten Seite 33 abgetragen werden. Dies kann beispielsweise über Abschleifen erfolgen. Um bei diesem Bearbeitungsschritt eine Beschädigung des rekonstruierten Wafers 30 zu vermeiden, ist es vorteilhaft, wenn dieser zwischenzeitlich auf einem vorliegend nicht dargestellten Hilfsträger angeordnet wird. Dieser wird danach wieder entfernt.

In einem vorliegend nicht dargestellten Ausführungsbeispiel, könnte zusätzlich oder alternativ zur der an der zweiten Seite 34 des rekonstruierten Wafers 30 ausgebildeten Umverteilungsschicht 20 auch an der ersten Seite 33 des rekonstruierten Wafers 30 eine Umverteilungsschicht 20 ausgebildet werden.

In den nachfolgenden Verfahrensschritten wird nun, insbesondere mit einem Ätzverfahren oder Laserbearbeitungsverfahren, von der ersten Seite 33 des rekonstruierten Wafers 30 ein Teil des rekonstruierten Wafers 30 bereichsweise bis zu der ersten Seite 16 des jeweils zugeordneten Piezoelements 4, 5 entfernt. Dies erfolgt derart, dass jeweils der Tragrahmen 3 und das im Inneren des Tragrahmens 3 angeordnete Koppelelement 9 ausgebildet wird.

Vorzugsweise wird während oder unmittelbar nach diesem Verfahrensschritt zur Ausbildung der Kontur des jeweiligen Piezoelements 4, 5 das Piezoelement 4, 5 selbst in einem Randbereich, insbesondere mittels eines Lasers, entfernt bzw. freigeschnitten.

Anschließend werden die jeweiligen Membrane 23 auf den rekonstruierten Wafer 30 aufgebracht. Die Membrane 23 können einzeln, insbesondere als Membraneinheiten 22, oder gemeinsam als zusammenhängendes Membranelement aufgebracht werden.

Danach werden die Piezoelemente 4, 5 freigestellt. Hierfür wird, insbesondere mit einem Ätzverfahren oder Laserbearbeitungsverfahren, von der der ersten Seite 16 gegenüberliegenden zweiten Seite 34 des rekonstruierten Wafers 30 ein Teil des rekonstruierten Wafers 30 bereichsweise bis zu der zweiten Seite 17 des jeweils zugeordneten Piezoelements 4, 5 entfernt.

In der nachfolgenden Beschreibung wird exemplarisch ein Ätzverfahren beschrieben. In Figur 8 ist der rekonstruierte Wafer 30 gedreht. Seine erste Seite 33 zeigt somit abbildungsgemäß nach oben und seine zweite Seite 34 nach unten. In dem in Figur 8 dargestellten Verfahrensschritt wird auf den rekonstruierten Wafer 30 eine erste Maskierungsschicht 35 aufgebracht. Vorliegend erfolgt dies an der ersten Seite 33 des rekonstruierten Wafers 30. Die erste Maskierungsschicht 35 weist mehrere den Chips 2 zugeordnete erste Öffnungen 36 auf. Infolgedessen ist jedem der Chips 2 zumindest eine erste Öffnung 36 zugeordnet. In dem vorliegenden Ausführungsbeispiel sind die ersten Öffnungen 36 jeweils derart ausgebildet, dass der rekonstruierte Wafer 30 in einem Außenbereich 37, der zur Ausbildung des in Figur 1 dargestellten Tragrahmens 3 des jeweiligen MEMS-Schallwandlers 1 vorgesehen ist, durch die erste Maskierungsschicht 35 bedeckt ist. Des Weiteren sind die ersten Öffnungen 36 in dem vorliegenden Ausführungsbeispiel jeweils derart ausgebildet, dass der rekonstruierte Wafer 30 in einem Innenbereich 38, der zur Ausbildung des in Figur 1 dargestellten Koppelelements 9 des jeweiligen MEMS-Schallwandlers 1 vorgesehenen ist, durch die erste Maskierungsschicht 35 maskiert ist. Der Außenbereich 37 bildet somit einen Rahmen, in dessen Inneren der Innenbereich 38 inselförmig angeordnet ist. Der Innenbereich 38 weist zum Außenbereich 37 keine Verbindung auf.

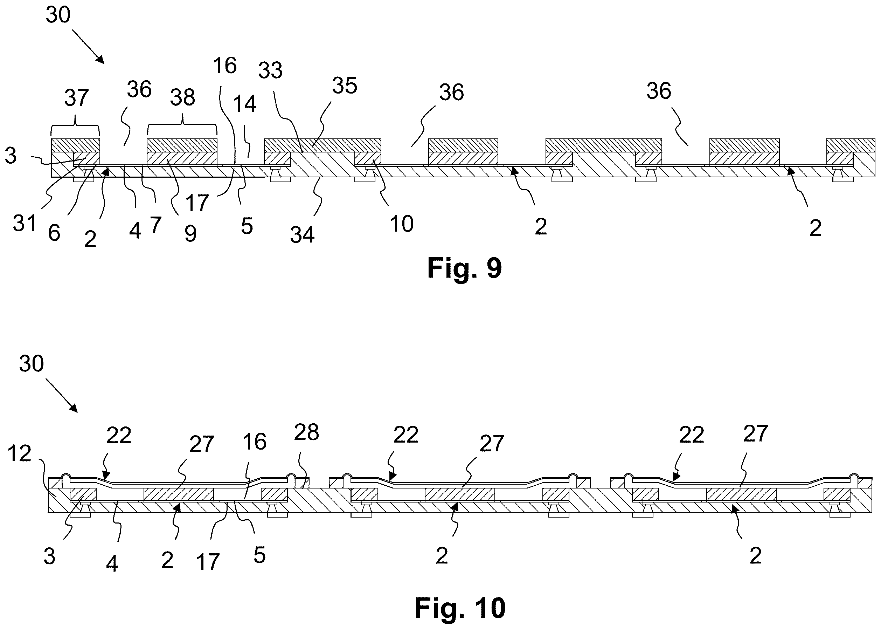

Nach dem Aufbringen der ersten Maskierungsschicht 35 wird auf den rekonstruierten Wafer 30 ein Ätzmittel aufgebracht. Dieses kommt im Bereich der ersten Öffnungen 36 mit dem rekonstruierten Wafer 30 in Kontakt, wodurch dieser, wie in Figur 9 dargestellt, teilweise weggeätzt wird. Aufgrund der Ausgestaltung der ersten Öffnungen 36 kommt das Ätzmittel in diesen Bereichen ausschließlich mit dem Substrat 10 des jeweiligen Chips 2 in Kontakt. Hierdurch wird der rekonstruierte Wafer 30, insbesondere das Substrat 10 des jeweiligen Chips 2, im Bereich der ersten Öffnungen 36 bis zu der ersten Seite 16 der piezoelektrischen Schicht 31 bzw. der aus dieser hergestellten Piezoelemente 4, 5 weggeätzt. Die Piezoelemente 4, 5 sind zu diesem Zeitpunkt noch nicht freigestellt, da sie an ihrer zweiten Seite 17 immer noch durch das Material der Formmasse 12 gehalten sind. Lediglich an der ersten Seite 16 des jeweiligen Piezoelements 4, 5 ist nunmehr der erste Hohlraum 14 ausgebildet. Des Weiteren wurde durch diesen Verfahrensschritt das Koppelelement 9 im Inneren dieses ersten Hohlraums 14 ausgebildet. Die Piezoelemente 4, 5 sind jeweils an ihrem einen Ende 6 mit dem Tragrahmen 3 und an ihrem anderen Ende 7 mit dem Koppelelement 9 verbunden. Eine Auslenkung entlang der Hubachse 8 ist zu diesem Zeitpunkt noch nicht möglich, da die Piezoelemente 4, 5 noch nicht freigestellt sind. Nach dem Ätzvorgang wird die erste Maskierungsschicht 35 wieder entfernt.

Vorzugsweise wird nach diesem Ätzvorgang zur Ausbildung der Kontur des jeweiligen Piezoelements 4, 5 das Piezoelement 4, 5 selbst in einem Randbereich, insbesondere mittels eines Lasers, freigeschnitten.

In dem in Figur 10 dargestellten Verfahrensschritt erfolgt für jeden der Chips 2 die Verbindung der jeweils zugeordneten Membran 23 mit den jeweils zugeordneten und noch nicht freigestellten Piezoelementen 4, 5.

In einem vorliegend nicht dargestellten Ausführungsbeispiel könnten die Membrane 23 gemeinsam als zusammenhängendes Membranelement aufgebracht werden. In diesem Fall würde auf der ersten Seite 33 des rekonstruierten Wafers 30 eine durchgängige Membranschicht bzw. das zusammenhängende Membranelement aufgebracht und in den Berührungsbereichen mit dem rekonstruierten Wafer 30 befestigt werden.

Alternativ können die Membrane 23 auf den rekonstruierten Wafer 30 gemäß dem vorliegenden Ausführungsbeispiel einzeln, insbesondere als Membraneinheiten 22, aufgebracht werden. Hierfür werden die Membraneinheiten 22 jeweils im ersten Verbindungsbereich 27 mit dem korrespondierenden Koppelelement 9 verbunden. Des Weiteren werden die Membranrahmen 24 jeweils im zweiten Verbindungsbereich 28 mit dem korrespondierenden Tragrahmen 3, insbesondere mittelbar über die Formmasse 12, verbunden. Da die Piezoelemente 4, 5 nicht freigestellt sind, sondern an ihrer zweiten Seite 17 immer noch durch die Formmasse 12 gehalten werden, kann die Membran 23 mit diesen, insbesondere mittelbar über das Koppelelement 9, im ersten Verbindungsbereich 27 verpresst werden, ohne dass diese durch die hohe Kraft ausgelenkt und beschädigt werden. Jedoch kann im ersten Verbindungsbereich 27 eine feste Verbindung, insbesondere Klebeverbindung, ausgebildet werden.

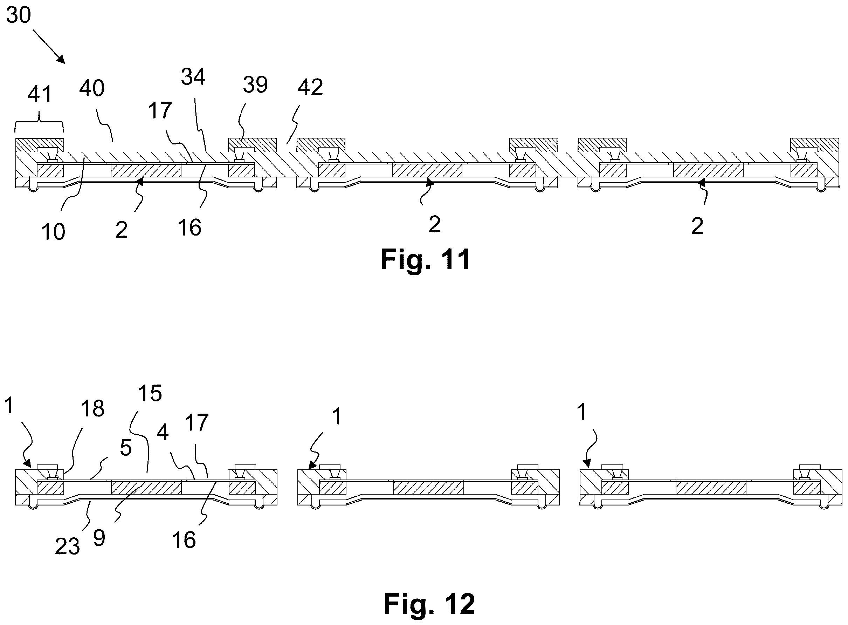

Erst nachdem die Membran 23 der jeweiligen Membraneinheit 22 mit den korrespondierenden Piezoelementen 4, 5 verbunden wurde, wird die jeweilige zweite Seite 17 der Piezoelemente 4, 5 freigelegt. Auch dies erfolgt über ein Maskierungs- und anschließendes Ätzverfahren. Hierfür wird gemäß Figur 11 eine zweite Maskierungsschicht 39 auf die zweite Seite 34 des rekonstruierten Wafers 30 aufgebracht. Die zweite Maskierungsschicht 39 umfasst zweite Öffnungen 40, von denen jeweils zumindest eine dem jeweiligen Chip 2 zugeordnet ist. Die zweiten Öffnungen 40 sind derart ausgebildet, dass der rekonstruierte Wafer 30 in einem für die Kavitätswandung 18 (vgl. Figur 1) des jeweiligen MEMS-Schallwandlers 1 vorgesehenen zweiten Außenbereich 41 durch die zweite Maskierungsschicht 39 maskiert ist. Die zweiten Öffnungen 40 sind rahmenförmig von der zweiten Maskierungsschicht 39 umgeben. Nach dem Aufbringen der zweiten Maskierungsschicht 39 wird ein Ätzmittel auf die zweite Seite 34 des rekonstruierten Wafers 30 aufgebracht. Hierdurch wird das Substrat 10 der Chips 2 bis zur zweiten Seite 17 der jeweiligen Piezoelemente 4, 5 weggeätzt. Nach dem Ätzen wird die zweite Maskierungsschicht 39 wieder entfernt.

Wie in Figur 12 dargestellt sind die Piezoelemente 4, 5 nach diesem Verfahrensschritt nicht nur an ihrer ersten Seite 16, sondern nunmehr auch an ihrer zweiten Seite 17 freigelegt. Die Piezoelemente 4,5 sind somit freigestellt. Infolgedessen können diese nunmehr gemeinsam mit dem Koppelelement 9 und/oder der jeweiligen Membran 23 entlang der Hubachse 8 ausgelenkt werden (vgl. Figur 1).

Gemäß Figur 11 weist die zweite Maskierungsschicht 39 gemäß dem vorliegenden Ausführungsbeispiel dritte Öffnungen 42 auf, die zwischen zwei MEMS-Schallwandlern 1 angeordnet sind. Die dritten Öffnungen 42 dienen dazu, die MEMS-Schallwandler 1 während des Ätzvorgangs voneinander zu trennen.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: MEMS-Schallwandler
- 2: Chips
- 3: Tragrahmen
- 4: erstes Piezoelement
- 5: zweites Piezoelement
- 6: erstes Ende des Piezoelements
- 7: zweites Ende des Piezoelements
- 8: Hubachse
- 9: Koppelelement
- 10: Substrat
- 11: Verbindungselement
- 12: Formmasse
- 13: Gehäuse
- 14: erster Hohlraum
- 15: zweiter Hohlraum
- 16: erste Seite des Piezoelements
- 17: zweite Seite des Piezoelements
- 18: Kavitätswandung
- 19: Kontaktstellen
- 20: Umverteilungsschicht
- 21: Durchkontaktierung
- 22: Membraneinheiten
- 23: Membran
- 24: Membranrahmen
- 25: Membranschicht
- 26: Versteifungsplatte
- 27: erster Verbindungsbereich
- 28: zweiter Verbindungsbereich
- 29: Wafer
- 30: rekonstruierter Wafer
- 31: piezoelektrische Schicht
- 32: Träger
- 33: erste Seite des rekonstruierten Wafers
- 34: zweite Seite des rekonstruierten Wafers
- 35: erste Maskierungsschicht
- 36: erste Öffnung
- 37: erster Außenbereich
- 38: Innenbereich
- 39: zweite Maskierungsschicht
- 40: zweite Öffnung
- 41: zweiter Außenbereich
- 42: dritte Öffnung

## Patentansprüche

1. Herstellungsverfahren für mehrere MEMS-Schallwandler (1) mit den folgenden Schritten:
- Herstellen eines rekonstruierten Wafers (30),
wobei mehrere Chips (2) eines Wafers (29) voneinander getrennt, die getrennten Chips (2) voneinander beabstandet angeordnet und mit einer Formmasse (12) umgossen werden,
- Freistellen zumindest eines Piezoelements (4, 5) der jeweiligen Chips (2), so dass dieses entlang einer Hubachse (8) auslenkbar ist, wobei die Piezoelemente (4, 5), erst nachdem die Chips (2) mit der Formmasse (12) umgossen wurden, freigestellt werden,
- Verbinden des rekonstruierten Wafers (30) mit mehreren den jeweiligen Chips (2) zugeordneten Membranen (23),
wobei die Membrane (23) jeweils mit dem zumindest einen zugeordneten Piezoelement (4, 5) derart verbunden werden, dass die Membrane (23), nachdem die Piezoelemente (4, 5) freigestellt wurden, jeweils gemeinsam mit dem zumindest einen zugeordneten Piezoelement (4, 5) entlang der Hubachse (8) auslenkbar sind, und
- Vereinzelung der MEMS-Schallwandler (1), die jeweils zumindest einen der Chips (2) und eine der Membrane (23) umfassen.

2. Herstellungsverfahren nach dem vorherigen Anspruch, **dadurch gekennzeichnet, dass** das zumindest eine Piezoelement (4, 5) der jeweiligen Chips (2) vor oder erst nach dem Verbinden mit der zugeordneten Membran (23) freigestellt wird.

3. Herstellungsverfahren nach einem oder mehreren der vorherigen Ansprüche, **dadurch gekennzeichnet, dass**, insbesondere mit einem Ätzverfahren oder Laserbearbeitungsverfahren, von einer ersten Seite (33) des rekonstruierten Wafers (30) ein Teil des rekonstruierten Wafers (30) bereichsweise bis zu einer ersten Seite (16) des jeweils zugeordneten Piezoelements (4, 5) entfernt wird, wobei der rekonstruierte Wafer (30) vorzugsweise von seiner ersten Seite (33) derart entfernt wird, dass für die MEMS-Schallwandler (1) jeweils ein Tragrahmen (3) und/oder ein im Inneren des Tragrahmens (3) angeordnetes Koppelelement (9) ausgebildet werden.

4. Herstellungsverfahren nach einem oder mehreren der vorherigen Ansprüche, **dadurch gekennzeichnet, dass** auf der ersten Seite (33) des rekonstruierten Wafers (30) eine erste Maskierungsschicht (35) angeordnet wird, die mehrere den Chips (2) zugeordnete erste Öffnungen (36) aufweist, und
dass auf diese erste Maskierungsschicht (35) ein Ätzmittel, insbesondere eine Flüssigkeit oder ein Gas, aufgebracht wird, so dass im Bereich der ersten Öffnungen (36) ein Teil des rekonstruierten Wafers (30) bis zu der ersten Seite (16) des jeweils zugeordneten Piezoelements (4, 5) weggeätzt wird.

5. Herstellungsverfahren nach einem oder mehreren der vorherigen Ansprüche, **dadurch gekennzeichnet, dass** die ersten Öffnungen (36) jeweils derart ausgebildet werden, dass der rekonstruierte Wafer (30) in einem für den Tragrahmen (3) des jeweiligen MEMS-Schallwandlers (1) vorgesehenen ersten Außenbereich (37) und/oder in einem für das Koppelelement (9) des jeweiligen MEMS-Schallwandlers (1) vorgesehenen Innenbereich (38) durch die erste Maskierungsschicht (35) maskiert ist, und/oder
dass der rekonstruierte Wafer (30), insbesondere von seiner ersten Seite (33) und/oder im Bereich der ersten Öffnungen (36), jeweils derart entfernt wird, dass das zumindest eine Piezoelement (4, 5) an einem ersten Ende (6) mit dem Tragrahmen (3) und/oder an einem zweiten Ende (7) mit dem Koppelelement (9) verbunden ist und/oder an seinen beiden gegenüberliegenden Längsseiten freigestellt ist.

6. Herstellungsverfahren nach einem oder mehreren der vorherigen Ansprüche, **dadurch gekennzeichnet, dass** das zumindest eine Piezoelement (4, 5) der jeweiligen Chips (2) nach dem Freilegen seiner ersten Seite (16), insbesondere im Bereich seines zweiten Endes (7) und/oder mittelbar über das Koppelelement (9), mit der Membran (23) verbunden wird und/oder
dass die Membran (23) an einem dem Piezoelement (4, 5) in Richtung der Hubachse (8) abgewandten Ende des Koppelelements (9) mit diesem verbunden wird und/oder
dass die Membran (23) unmittelbar oder mittelbar über einen die Membran (23) in ihrem Randbereich haltenden Membranrahmen (24) mit dem Tragrahmen (3) verbunden wird.

7. Herstellungsverfahren nach einem oder mehreren der vorherigen Ansprüche, **dadurch gekennzeichnet, dass** die Membrane (23) auf den rekonstruierten Wafer (30) einzeln, insbesondere als Membraneinheiten (22), oder gemeinsam als zusammenhängendes Membranelement aufgebracht werden.

8. Herstellungsverfahren nach einem oder mehreren der vorherigen Ansprüche, **dadurch gekennzeichnet, dass**, insbesondere mit einem Ätzverfahren oder Laserbearbeitungsverfahren, von einer der ersten Seite (16) gegenüberliegenden zweiten Seite (34) des rekonstruierten Wafers (30) ein Teil des rekonstruierten Wafers (30) bereichsweise bis zu einer zweiten Seite (17) des jeweils zugeordneten Piezoelements (4, 5) entfernt wird und/oder
dass zum Freistellen des zumindest einen Piezoelements (4, 5) auf der zweiten Seite (34) des rekonstruierten Wafers (30) eine zweite Maskierungsschicht (39) angeordnet wird, die mehrere den Chips (2) zugeordnete zweite Öffnungen (40) aufweist, und
dass auf diese zweite Maskierungsschicht (39) ein Ätzmittel aufgebracht wird, so dass im Bereich der zweiten Öffnungen (40) ein Teil des rekonstruierten Wafers (30) bis zu der zweiten Seite (17) des jeweils zugeordneten Piezoelements (4, 5) weggeätzt wird.

9. Herstellungsverfahren nach einem oder mehreren der vorherigen Ansprüche, **dadurch gekennzeichnet, dass** die zweiten Öffnungen (40) jeweils derart ausgebildet werden, dass der rekonstruierte Wafer (30) in einem für eine Kavitätswandung (18) des jeweiligen MEMS-Schallwandlers (1) vorgesehenen zweiten Außenbereich (41) durch die zweite Maskierungsschicht (39) maskiert ist.

10. Herstellungsverfahren nach einem oder mehreren der vorherigen Ansprüche, **dadurch gekennzeichnet, dass** zur Ausbildung der Kontur des Piezoelements (4, 5) das Piezoelement (4, 5) selbst in einem Randbereich, insbesondere mittels eines Lasers, entfernt wird.

11. Herstellungsverfahren nach einem oder mehreren der vorherigen Ansprüche, **dadurch gekennzeichnet, dass** das Piezoelement (4, 5) selbst in seinem Randbereich entweder nach dem Freilegen seiner ersten Seite (16) oder nach dem Freilegen seiner zweiten Seite (17) konturiert wird.

12. Herstellungsverfahren nach einem oder mehreren der vorherigen Ansprüche, **dadurch gekennzeichnet, dass** zur Herstellung des rekonstruierten Wafers (30) die voneinander getrennten Chips (2) vor dem Umgießen mit der Formmasse (12) auf einem Träger (32) angeordnet werden und/oder
dass der Träger (32) nach dem Aushärten der Formmasse (12) entfernt wird, so dass die Chips (2) in der Formmasse (12) eingekapselt sind und an der ersten Seite (33) des rekonstruierten Wafers (30) freiliegen.

13. Herstellungsverfahren nach einem oder mehreren der vorherigen Ansprüche, **dadurch gekennzeichnet, dass** auf der zweiten Seite (34) des rekonstruierten Wafers (30) ein Hilfsträger angebracht wird und/oder der rekonstruierte Wafer (30) an seiner ersten Seite (33) zur Reduktion seiner Dicke teilweise abgetragen wird.

14. Herstellungsverfahren nach einem oder mehreren der vorherigen Ansprüche, **dadurch gekennzeichnet, dass** auf der ersten und/oder zweiten Seite (33, 34) des rekonstruierten Wafers (30) eine elektrische Isolationsschicht und/oder eine Umverteilungsschicht (20) zum Umverteilen von Kontaktstellen (19) des jeweiligen Chips (2) aufgebracht werden.

## Claims

1. A manufacturing method for multiple MEMS sound transducers (1), including the following steps:
- manufacturing a reconstructed wafer (30),
wherein multiple chips (2) of a wafer (29) are separated from one another,
the separated chips (2) are arranged spaced apart from one another and
are encapsulated in a molding material (12);
- exposing at least one piezoelectric element (4, 5) of the particular chips (2), so that this is deflectable along a stroke axis (8), wherein the piezoelectric elements (4, 5) are exposed only after the chips (2) have been encapsulated in the molding material (12);
- connecting the reconstructed wafer (30) to multiple diaphragms (23) associated with the particular chips (2),
wherein the diaphragms (23) are each connected to the at least one associated piezoelectric element (4, 5) in such a way that, after the piezoelectric elements (4, 5) have been exposed, the diaphragms (23) are each deflectable together with the at least one associated piezoelectric element (4, 5) along the stroke axis (8), and
- isolating the MEMS sound transducers (1), each of which comprises at least one of the chips (2) and one of the diaphragms (23).

2. The manufacturing method as claimed in the preceding claim, **characterized in that** the at least one piezoelectric element (4, 5) of the particular chips (2) is exposed before or only after the connection to the associated diaphragm (23).

3. The manufacturing method as claimed in one or multiple of the preceding claims, **characterized in that** a portion of the reconstructed wafer (30) is removed, area by area, up to a first side (16) of the particular associated piezoelectric element (4, 5) from a first side (33) of the reconstructed wafer (30), in particular using an etching method or a laser machining method, wherein the reconstructed wafer (30) is preferably removed from its first side (33) in such a way that a support frame (3) and/or a coupling element (9) arranged in the interior of the support frame (3) are/is formed for each of the MEMS sound transducers (1).

4. The manufacturing method as claimed in one or multiple of the preceding claims, **characterized in that** a first masking layer (35), which comprises multiple first openings (36) associated with the chips (2), is arranged on the first side (33) of the reconstructed wafer (30) and
an etchant, in particular a fluid or a gas, is applied onto this first masking layer (35), so that, in the region of the first openings (36), a portion of the reconstructed wafer (30) is etched away up to the first side (16) of the particular associated piezoelectric element (4, 5).

5. The manufacturing method as claimed in one or multiple of the preceding claims, **characterized in that** the first openings (36) are each designed in such a way that the reconstructed wafer (30) is masked by the first masking layer (35) in a first outer region (37) provided for the support frame (3) of the particular MEMS sound transducer (1) and/or in an inner region (38) provided for the coupling element (9) of the particular MEMS sound transducer (1) and/or
the reconstructed wafer (30) is removed, in particular from its first side (33) and/or in the region of the first openings (36), in such a way in each case that the at least one piezoelectric element (4, 5) is connected, at a first end (6), to the support frame (3) and/or, at a second end (7), to the coupling element (9) and/or is exposed on its two opposite longitudinal sides.

6. The manufacturing method as claimed in one or multiple of the preceding claims, **characterized in that** the at least one piezoelectric element (4, 5) of the particular chips (2) is connected to the diaphragm (23), in particular in the region of its second end (7) and/or indirectly via the coupling element (9), after the exposure of its first side (16) and/or
the diaphragm (23) is connected to the coupling element (9) at an end of the coupling element (9) facing away from the piezoelectric element (4, 5) in the direction of the stroke axis (8), and/or
the diaphragm (23) is connected to the support frame (3) directly or indirectly via a diaphragm frame (24) holding the diaphragm (23) in its edge region.

7. The manufacturing method as claimed in one or multiple of the preceding claims, **characterized in that** the diaphragm (23) is mounted onto the reconstructed wafer (30) individually, in particular as diaphragm units (22), or jointly as a contiguous diaphragm element.

8. The manufacturing method as claimed in one or multiple of the preceding claims, **characterized in that** a portion of the reconstructed wafer (30) is removed, area by area, up to a second side (17) of the particular associated piezoelectric element (4, 5) from a second side (34) of the reconstructed wafer (30) opposite the first side (16), in particular using an etching method or a laser machining method and/or
in order to expose the at least one piezoelectric element (4, 5), a second masking layer (39), which comprises multiple second openings (40) associated with the chips (2), is arranged on the second side (34) of the reconstructed wafer (30), and
an etchant is applied onto this second masking layer (39), so that, in the region of the second openings (40), a portion of the reconstructed wafer (30) is etched away up to the second side (17) of the particular associated piezoelectric element (4, 5).

9. The manufacturing method as claimed in one or multiple of the preceding claims, **characterized in that** the second openings (40) are each designed in such a way that the reconstructed wafer (30) is masked by the second masking layer (39) in a second outer region (41) provided for a cavity wall (18) of the particular MEMS sound transducer (1).

10. The manufacturing method as claimed in one or multiple of the preceding claims, **characterized in that** the piezoelectric element (4, 5) itself is removed in an edge region, in particular with the aid of a laser, in order to form the contour of the piezoelectric element (4, 5).

11. The manufacturing method as claimed in one or multiple of the preceding claims, **characterized in that** the piezoelectric element (4, 5) itself is contoured in its edge region either after the exposure of its first side (16) or after the exposure of its second side (17).

12. The manufacturing method as claimed in one or multiple of the preceding claims, **characterized in that**, in order to manufacture the reconstructed wafer (30), the chips (2), which have been separated from one another, are arranged on a carrier (32) before the encapsulation in the molding material (12) and/or
the carrier (32) is removed after the molding material (12) has cured, so that the chips (2) are encapsulated in the molding material (12) and are exposed on the first side (33) of the reconstructed wafer (30).

13. The manufacturing method as claimed in one or multiple of the preceding claims, **characterized in that** an auxiliary carrier is mounted on the second side (34) of the reconstructed wafer (30), and/or the reconstructed wafer (30) is partially ground off on its first side (33) in order to reduce its thickness.

14. The manufacturing method as claimed in one or multiple of the preceding claims, **characterized in that** an electrical insulation layer and/or a redistribution layer (20) for redistributing contact points (19) of the particular chip (2) are applied on the first and/or the second side (33, 34) of the reconstructed wafer (30).

## Revendications

1. Procédé de fabrication de plusieurs transducteurs acoustiques MEMS (1), comprenant les étapes consistant à :
- fabriquer une plaquette reconstituée (30),
dans lequel plusieurs puces (2) d'une plaquette (29) sont séparées les unes des autres, les puces (2) séparées sont disposées à distance les unes des autres et enrobées d'une matière à mouler (12),
- dégager au moins un élément piézoélectrique (4, 5) des différentes puces (2), de sorte que celui-ci peut être dévié le long d'un axe de course (8), les éléments piézoélectriques (4, 5) n'étant dégagés qu'après que les puces (2) ont été enrobées de la matière à mouler (12),
- relier la plaquette reconstituée (30) à plusieurs membranes (23) associées aux différentes puces (2),
dans lequel les membranes (23) sont reliées chacune à l'au moins un élément piézoélectrique (4, 5) associé de sorte que les membranes (23), après que les éléments piézoélectriques (4, 5) ont été dégagés, peuvent être déviées chacune conjointement avec l'au moins un élément piézoélectrique (4, 5) associé le long de l'axe de course (8), et
- isolement des transducteurs acoustiques MEMS (1), qui comprennent chacun au moins l'une des puces (2) et l'une des membranes (23).

2. Procédé de fabrication selon la revendication précédente, **caractérisé en ce que** le, au moins un, élément piézoélectrique (4, 5) des différentes puces (2) est dégagé avant ou seulement après la liaison avec la membrane (23) associée.

3. Procédé de fabrication selon l'une quelconque ou plusieurs des revendications précédentes, **caractérisé en ce qu'**une partie de la plaquette reconstituée (30) est enlevée en certaines zones depuis un premier côté (33) de la plaquette reconstituée (30) jusqu'à un premier côté (16) de l'élément piézoélectrique (4, 5) respectivement associé, en particulier par un procédé d'usinage par corrosion ou un procédé d'usinage au laser, dans lequel la plaquette reconstituée (30) est de préférence enlevée depuis son premier côté (33) de sorte que, pour les transducteurs acoustiques MEMS (1), il se forme respectivement un cadre-porteur (3) et/ou un élément de couplage (9) disposé à l'intérieur du cadre-porteur (3).

4. Procédé de fabrication selon l'une quelconque ou plusieurs des revendications précédentes, **caractérisé en ce qu'**une première couche de masquage (35) est disposée sur le premier côté (33) de la plaquette reconstituée (30), laquelle couche de masquage comporte plusieurs premières ouvertures (36) associées aux puces (2), et
**en ce qu'**un agent corrosif, en particulier un liquide ou un gaz, est appliqué sur cette première couche de masquage (35), de sorte que, dans la zone des premières ouvertures (36), une partie de la plaquette reconstituée (30) est enlevée par corrosion jusqu'au premier côté (16) de l'élément piézoélectrique (4, 5) respectivement associé.

5. Procédé de fabrication selon l'une quelconque ou plusieurs des revendications précédentes, **caractérisé en ce que** les premières ouvertures (36) sont formées chacune de sorte que la plaquette reconstituée (30) soit masquée par la première couche de masquage (35) dans une première zone extérieure (37) prévue pour le cadre-porteur (3) du transducteur acoustique MEMS (1) respectif et/ou dans une zone intérieure (38) prévue pour l'élément de couplage (9) du transducteur acoustique MEMS (1) respectif, et/ou
**en ce que** la plaquette reconstituée (30) est retirée, en particulier par son premier côté (33) et/ou dans la zone des premières ouvertures (36), respectivement de sorte que le, au moins un, élément piézoélectrique (4, 5) est relié à une première extrémité (6) au cadre-porteur (3) et/ou à une deuxième extrémité (7) à l'élément de couplage (9) et/ou est dégagé sur ses deux côtés longitudinaux opposés l'un à l'autre.

6. Procédé de fabrication selon l'une quelconque ou plusieurs des revendications précédentes, **caractérisé en ce que** le, au moins un, élément piézoélectrique (4, 5) des différentes puces (2) est relié à la membrane (23) après le dégagement de son premier côté (16), en particulier dans la zone de sa deuxième extrémité (7) et/ou indirectement via l'élément de couplage (9), et/ou
**en ce que** la membrane (23) est reliée à l'élément de couplage (9) à une extrémité de celui-ci opposée à l'élément piézoélectrique (4, 5) dans la direction de l'axe de course (8) et/ou
**en ce que** la membrane (23) est reliée directement ou indirectement au cadre-porteur (3) via un cadre (24) de membrane tenant la membrane (23) dans sa zone de bordure.

7. Procédé de fabrication selon l'une quelconque ou plusieurs des revendications précédentes, **caractérisé en ce que** les membranes (23) sont appliquées sur la plaquette reconstituée (30) individuellement, en particulier sous forme d'unités de membrane (22), ou ensemble sous forme d'élément de membrane cohérent.

8. Procédé de fabrication selon l'une quelconque ou plusieurs des revendications précédentes, **caractérisé en ce qu'**une partie de la plaquette reconstituée (30) est enlevée en certaines zones depuis un deuxième côté (34) de la plaquette reconstituée (30) opposé au premier côté (16), jusqu'à un deuxième côté (17) de l'élément piézoélectrique (4, 5) respectivement associé, et/ou
**en ce que**, pour le dégagement de l'au moins un élément piézoélectrique (4, 5), une deuxième couche de masquage (39) est disposée sur le deuxième côté (34) de la plaquette reconstituée (30), laquelle couche de masquage comporte plusieurs deuxièmes ouvertures (40) associées aux puces (2), et
**en ce qu'**un agent corrosif est appliqué sur cette deuxième couche de masquage (39), de sorte que, dans la zone des deuxièmes ouvertures (40), une partie de la plaquette reconstituée (30) est enlevée par corrosion jusqu'au deuxième côté (17) de l'élément piézoélectrique (4, 5) respectivement associé.

9. Procédé de fabrication selon l'une quelconque ou plusieurs des revendications précédentes, **caractérisé en ce que** les deuxièmes ouvertures (40) sont formées chacune de sorte que la plaquette reconstituée (30) est masquée par la deuxième couche de masquage (39) dans une deuxième zone extérieure (41) prévue pour une paroi (18) de cavité du transducteur acoustique MEMS (1) respectif.

10. Procédé de fabrication selon l'une quelconque ou plusieurs des revendications précédentes, **caractérisé en ce que** pour former le contour de l'élément piézoélectrique (4, 5), l'élément piézoélectrique (4, 5) lui-même est enlevé dans une zone de bordure, notamment au moyen d'un laser.

11. Procédé de fabrication selon l'une quelconque ou plusieurs des revendications précédentes, **caractérisé en ce que** l'élément piézoélectrique (4, 5) est lui-même contouré dans sa zone de bordure, soit après le dégagement de son premier côté (16), soit après le dégagement de son deuxième côté (17).

12. Procédé de fabrication selon l'une quelconque ou plusieurs des revendications précédentes, **caractérisé en ce que**, pour la fabrication de la plaquette reconstituée (30), les puces (2) séparées les unes des autres sont disposées sur un support (32) avant l'enrobage avec la matière à mouler (12) et/ou
**en ce que** le support (32) est retiré après le durcissement de la matière à mouler (12), de sorte que les puces (2) sont encapsulées dans la matière à mouler (12) et sont exposées sur le premier côté (33) de la plaquette reconstituée (30).

13. Procédé de fabrication selon l'une quelconque ou plusieurs des revendications précédentes, **caractérisé en ce qu'**un support auxiliaire est monté sur le deuxième côté (34) de la plaquette reconstituée (30), et/ou la plaquette reconstituée (30) est partiellement enlevée sur son premier côté (33) afin de réduire son épaisseur.

14. Procédé de fabrication selon l'une quelconque ou plusieurs des revendications précédentes, **caractérisé en ce qu'**une couche d'isolation électrique et/ou une couche de répartition (20) pour répartir les points de contact (19) de la puce (2) respectives ont appliquées sur le premier et/ou le deuxième côté (33, 34) de la plaquette reconstituée (30).
